Europäisches Patentamt

European Patent Office

Office européen des brevets

(19)

(11) Numéro de publication: **0 119 547**
**A1**

(12) **DEMANDE DE BREVET EUROPEEN**

(21) Numéro de dépôt: **84102412.8**

(22) Date de dépôt: **07.03.84**

(51) Int. Cl.³: **G 01 R 31/36, H 01 M 10/44**

(30) Priorité: **16.03.83 FR 8304430**

(43) Date de publication de la demande: **26.09.84**
**Bulletin 84/39**

(84) Etats contractants désignés: **CH DE GB LI**

(71) Demandeur: **ASULAB S.A., Faubourg du Lac 6, CH-2501 Bienne (CH)**

(72) Inventeur: **Randin, Jean-Paul, Potat-Dessus 13, CH-2016 Cortaillod (CH)**
Inventeur: **Zuellig, Frédy, Saint-Germain 2, CH-2800 Delemont (CH)**
Inventeur: **Jeanmonod, Roland, Rue Louis d'Orléans 41, CH-2006 Neuchatel (CH)**

(74) Mandataire: **Gresset, Jean et al, ASUAG Département Brevets et Licences Faubourg du Lac 6, CH-2501 Bienne (CH)**

(54) **Procédé de mesure de l'état de décharge d'une pile et appareil mettant en oeuvre ce procédé.**

(57)    L'invention concerne un procédé de mesure de l'état de décharge (D) d'une pile, défini comme étant le rapport entre la capacité fournie et la capacité nominale de la pile, exprimées en ampères-heures.

Le procédé selon l'invention consiste à déterminer la pente, à un instant de mesure ($t_3$) convenablement choisi, de la tangente à la courbe représentant la variation de la tension (E) de la pile en fonction du temps (t), pendant que la pile est déchargée par un courant de mesure constant (i), et de prendre cette pente comme grandeur représentative de l'état de décharge de la pile.

Ce procédé peut avantageusement être utilisé pour tester de façon rapide, précise et non-destructive les piles destinées à des appareils portables, par exemple des montres électroniques, afin de s'assurer du bon état de la pile avant sa mise en place dans l'appareil.

PROCEDE DE MESURE DE L'ETAT DE DECHARGE D'UNE PILE ET APPAREIL METTANT EN OEUVRE CE PROCEDE

La présente invention concerne un procédé de mesure ou de test non destructif permettant de déterminer l'état de décharge d'une pile. Elle concerne également un appareil ou instrument mettant en oeuvre ce procédé de mesure.

Une pile est caractérisée électriquement par la tension électrique à circuit ouvert existant entre ses bornes, par sa résistance interne et par sa capacité. Cette dernière, exprimée en général en ampères-heures (Ah) ou en milliampères-heures (mAh), indique quel courant la pile peut fournir pendant un laps de temps donné, avant que sa tension sous une charge appropriée ne descende en dessous d'une valeur prédéterminée.

Pour une pile usagée, le rapport entre les Ah qu'elle a fourni sur une charge et sa capacité nominale définit l'état de décharge de la pile, grandeur désignée par D et exprimée en général en %.

Alors que la tension à circuit ouvert d'une pile d'un type donné est un paramètre bien connu et stable, sa capacité peut présenter une certaine dispersion par rapport à la valeur nominale. L'état de décharge d'une pile dépend, de son côté, de la façon dont elle a été utilisée ou même stockée, donc de son histoire. En effet même à l'état de stockage une pile a tendance à se décharger, ce qui fait que son état de décharge est impossible à connaître avec précision, sinon par une mesure.

Les procédés connus de détermination de l'état de décharge D d'une pile sont malheureusement difficiles à mettre en oeuvre et peu précis. Ils reposent essentiellement soit sur la mesure de la résistance R ou de l'impédance complexe Z de la pile, soit sur la mesure de sa tension E sous charge, c'est-à-dire lorsque la pile débite un courant i. Ce sont en effet les seuls paramètres qui varient de façon significative en fonction de l'état de décharge de la pile.

Le procédé de mesure de D basé sur la détermination de l'impédance complexe est bien connu et il est décrit par exemple dans les articles de S.A.G.R. Karunathilaka et al dans la revue Journal of Applied Electrochemistry, 10 (1980), pp 799-806 et 11 (1981), pp 573-582. Les résultats obtenus en appliquant cette méthode à de petites piles, comme celles utilisées dans les montres, sont cependant peu précis et varient beaucoup d'un échantillon à un autre.

Un autre procédé consiste à soumettre la pile à une rampe de courant augmentant avec le temps de façon constante. La tension que la pile atteint après un certain temps ou pour un courant donné, ou encore la valeur de sa résistance en courant continu, donnée par la tangente à la courbe $E = f(i)$, peuvent être prises comme valeurs représentatives de l'état de décharge de la pile, ainsi que cela est montré dans l'article de J.J. Winter et al, Journal of Electrochem. Soc. 122 (1975) pp 1434-1438 ou dans le brevet US 4,204,162 Froidevaux, mai 1980. Ce procédé, compliqué à mettre en oeuvre, s'est révélé être également peu précis.

Enfin un procédé galvanostatique a été proposé par F. Kornfeil dans l'article "Some observations on the prediction of the state of discharge of batteries", Journal of Electrochem. Soc. 123 (1976) pp 1271-1276. Il consiste à faire débiter par la pile un courant constant et à prendre comme grandeur représentative de son état de décharge la tension qu'elle présente au bout d'un temps prédéterminé. Les résultats obtenus par ce procédé de mesure présentent une précision satisfaisante. Cependant la résistance de la pile, laquelle dépend de son état de décharge et varie d'un échantillon à un autre, provoque une chute de tension au moment de l'enclenchement du courant constant et introduit dans les mesures une dispersion indésirable.

L'objet principal de l'invention est de fournir un procédé de mesure du type galvanostatique dans lequel la résistance de la pile n'intervient plus dans la détermination de son état de décharge.

Plusieurs méthodes peuvent être envisagées pour atteindre ce but. On pourrait par exemple mesurer la tension après un temps prédéterminé et corriger cette valeur de la chute de tension ohmique iR dans la pile. Ce procédé nécessiterait une mesure complémentaire de la résistance R de la pile au moment de la mesure galvanostatique. De plus, cette façon de faire donnerait une tension corrigée de la chute ohmique mais qui dépendrait encore fortement des phénomènes d'activation qui se manifestent au début de la mesure.

Une méthode différente, consistant à déterminer l'instant de transition $\tau$, défini comme étant l'instant à partir duquel la tension de la batterie sous charge commence à diminuer très rapidement, aurait pour inconvénient un long temps de mesure qui implique une diminution de la capacité relativement importante et une longue période de récupération des caractéristiques de la pile.

Un autre but de l'invention est d'éliminer les phénomènes qui changent peu en fonction de l'état de décharge, comme par exemple l'activation, pour ne conserver que ceux pour lesquels la variation est la plus significative.

Pour atteindre ces objectifs, le procédé de mesure de l'état de décharge d'une pile selon l'invention consistant :
- à décharger la pile par un courant de mesure constant à partir d'un instant initial,
- est principalement remarquable en ce qu'il consiste en outre à mesurer, à un instant de mesure, la pente de la tangente à la courbe représentant la variation de la tension de la pile en fonction du temps, cette pente étant représentative de l'état de décharge de la pile.

Un avantage du procédé de mesure selon l'invention est que la chute de tension due à la résistance de la pile au moment de l'enclenchement du courant de décharge ne vient plus fausser la détermination de la capacité restante de la pile. Ceci permet d'améliorer sensiblement la précision de la mesure de son état de décharge.

Un autre avantage du procédé de mesure selon l'invention est que la chute de tension due au phénomène d'activation à l'interface électrode/électrolyte n'est plus comprise dans la valeur mesurée, pour autant que le temps auquel on fait les mesures soit convenablement choisi.

L'invention a encore pour objet de fournir un appareil de mesure permettant de déterminer de façon rapide, précise et non destructive l'état de décharge d'une pile sans diminuer sa capacité de façon significative, en mettant en oeuvre le procédé de mesure selon l'invention.

Le dessin annexé illustre un procédé de mesure connu et, à titre d'exemple nullement limitatif, un procédé selon l'invention ainsi qu'un appareil de mesure mettant en oeuvre ce procédé; sur ce dessin :

- la figure 1 représente le schéma de principe d'un circuit connu permettant de déterminer l'état de décharge D d'une pile par le procédé galvanostatique;

- la figure 2 montre comment varie la tension E aux bornes d'une pile en fonction du temps t, lorsqu'elle est mesurée avec un courant de décharge constant i;

- la figure 3 montre la variation de la tension aux bornes d'une même pile en fonction du temps pour deux états de décharge différents D et D', la pile débitant un même courant constant i dans les deux cas;

- la figure 4 montre la relation existant entre la tension $E_2$ d'une pile mesurée dans le procédé galvanostatique connu et son état de décharge D;

- la figure 5 montre la relation existant entre la pente de la tangente à la courbe représentant la variation de la tension E d'une pile en fonction du temps à un instant de mesure $t_3$ donné, obtenue par le procédé du type galvanostatique décrit par la présente invention, et l'état de décharge D de la pile;

- la figure 6 montre la relation existant entre la pente de la tangente à la courbe représentant la variation de la tension E de la pile et le rapport $(t_3-t_0)/(\tau-t_0)$; enfin

- la figure 7 représente le schéma d'un appareil de mesure mettant en oeuvre le procédé selon l'invention.

Le principe de mesure selon l'invention étant basé sur le procédé galvanostatique décrit dans l'article de F. Kornfeil déjà cité, ce procédé va d'abord être décrit pour faire apparaître plus clairement les avantages de l'invention.

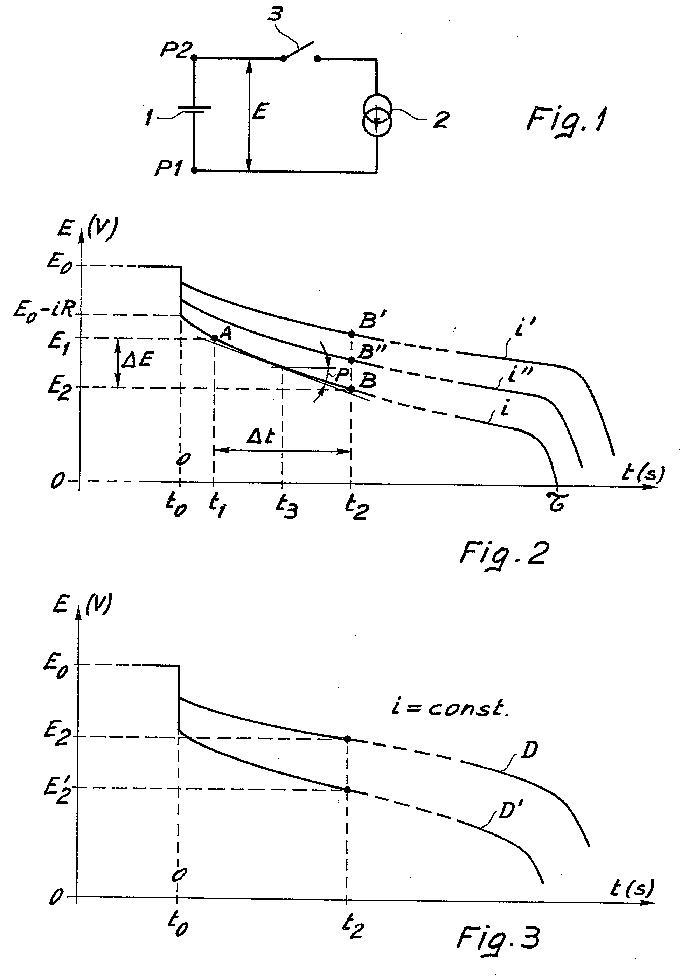

Dans ce procédé il est fait usage d'un circuit de mesure dont le schéma de principe est représenté sur la figure 1. La pile à mesurer 1 a pour pôles $P_1$ et $P_2$. La borne $P_1$ est reliée à une première borne d'une source de courant 2 susceptible de débiter un courant constant i. La borne $P_2$, de son côté, est reliée à une première borne d'un interrupteur 3, la seconde borne de cet interrupteur étant reliée à la seconde borne de la source de courant 2. La fermeture de l'interrupteur 3 permet de boucler le circuit formé par la pile 1 et le générateur 2 et de faire débiter par la pile un courant de mesure constant i.

Aussi longtemps que l'interrupteur 3 est ouvert, la tension E entre les bornes $P_1$, $P_2$ de la pile 1 reste égale à la tension à circuit ouvert ou à vide $E_0$. Dès la fermeture de cet interrupteur, à un instant initial arbitraire $t_0 = 0$, le courant de mesure i généré par la source de courant 2 produit dans la résistance R de la pile une brusque chute de tension iR ramenant la tension E de la pile à la valeur $E = E_0 - iR$, comme il est montré sur la figure 2.

La tension de la pile baisse ensuite progressivement en fonction du temps, cette baisse de tension étant produite par le courant de mesure i. L'évolution de la tension de la pile reflète les phénomènes d'activation et de concentration qui prennent place aux interfaces électrode/électrolyte. Au bout d'un certain temps, à un instant $\tau$ appelé instant de transition, compté à partir de l'instant initial $t_0$, la tension de la pile commence à diminuer rapidement. Cette brusque chute de tension est due à une forte diminution de la concentration en ions diffusants aux interfaces électrode/électrolyte.

La variation de la tension de la pile avec le temps et l'instant de transition $\tau$ dépendent de l'intensité du courant de mesure i. Plus cette intensité est élevée, plus la tension diminue rapidement et plus $\tau$ est petit. La relation liant le courant de mesure i à l'instant de transition $\tau$ est connue sous le nom d'équation de Sand et elle est de la forme $i(\tau - t_0)^{1/2} = $ constante. Sur la figure 2, trois courbes de décharge typiques sont représentées pour les courants i', i'' et i, pris dans l'ordre croissant des intensités.

Le procédé galvanostatique connu consiste à mesurer la tension de la pile à un instant $t_2$, après un temps de décharge $t_2 - t_0$, petit par rapport à l'intervalle de transition $\tau - t_0$, la pile étant à l'état frais au départ. Sur les courbes i', i'', i de la figure 2 les points associés à l'instant $t_2$ sont désignés par B', B'' et B et correspondent respectivement aux tensions $E'_2$, $E''_2$, $E_2$ de la pile. Sur cette figure on voit la forte dépendance de la tension $E_2$ de la valeur du courant de mesure i.

Considérons maintenant les courbes de décharge représentées sur la figure 3, obtenues à partir d'une même pile prise à deux états de décharge D et D' différents. La courbe D correspond, dans ce cas, à l'état de décharge le plus faible par exemple lorsque la pile est neuve, et D' à un état de décharge avancé. Le même courant de mesure i est utilisé dans les deux cas. On voit qu'à l'instant initial $t_0$ la chute de tension aux bornes de la pile provoquée par le courant i est plus grande lorsque la pile est fortement déchargée que lorsqu'elle est neuve. Cela signifie que la résistance interne R de la pile augmente à mesure que son état de décharge D augmente également. Bien que cet exemple soit un cas particulier mais fréquent, on observe parfois pour certaines piles que la résistance interne diminue ou reste constante quand l'état de décharge augmente.

Il résulte de ce qui précède que la détermination de l'état de décharge D d'une pile par la méthode galvanostatique connue, consistant à mesurer la tension $E_2$ aux bornes de la pile après que celle-ci ait débité un courant constant i pendant un intervalle de temps $t_2$-$t_0$, est peu précise du fait des variations possibles de la résistance interne R et de la chute de tension due au phénomène d'activation à l'interface électrode/électrolyte. Cette incertitude de mesure est représentée sur la figure 4 par la largeur de la zone hachurée s'étendant entre les courbes 10, 11 qui définissent les limites extrêmes entre lesquelles se situe D pour une valeur donnée $E_2$.

Afin d'améliorer la précision et la fiabilité de la détermination de l'état de décharge D d'une pile, le procédé du type galvanostatique selon l'invention consiste à mesurer la pente de la tangente à la courbe de la tension de la pile en fonction du temps à un instant $t_3$ convenablement choisi, alors que la pile débite un courant constant i, comme cela est montré sur la figure 2. De nombreux essais ont montré que cette pente, désignée par p, est une grandeur qui est bien représentative de l'état de décharge D de la pile.

La détermination de la pente p nécessite une mesure supplémentaire à un instant $t_1$, compris entre les instants $t_0$ et $t_2$, de la tension $E_1$ de la pile. Cette mesure définit le point A de la courbe i de la figure 2 et l'écart de tension $\Delta E = E_1 - E_2$ divisé par l'intervalle de temps $\Delta t = t_2 - t_1$ donne la pente, soit $p = \Delta E/\Delta t$. Si les instants $t_1$ et $t_2$ sont suffisamment rapprochés, on pourra considérer que la pente p ainsi définie l'est pour tout instant de mesure $t_3$, situé entre $t_1$ et $t_2$.

Si dans une série de mesures l'intervalle de temps $\Delta t$ est constant, il est évident que l'écart de tension $\Delta E$ est aussi représentatif de l'état de décharge D de la pile que la pente p.

Dans le cas d'une pile horlogère ayant une capacité nominale de l'ordre de 50 mAh, les conditions de mesure sont typiquement les suivantes: $t_1-t_0$ = 10 sec, $t_2-t_0$ = 40 sec et i = 20 mA. Un calcul simple montre alors que la capacité soustraite à la pile pour déterminer son état de décharge D correspond à environ 0.3 % de sa capacité nominale, ce qui peut être considéré comme négligeable.

De nombreux essais ont montré que, en pratique, le courant de décharge de la pile pendant la mesure, exprimée en mA, peut être choisi entre 0,05 fois et 4 fois la valeur de la capacité de la pile, exprimée en mAh.

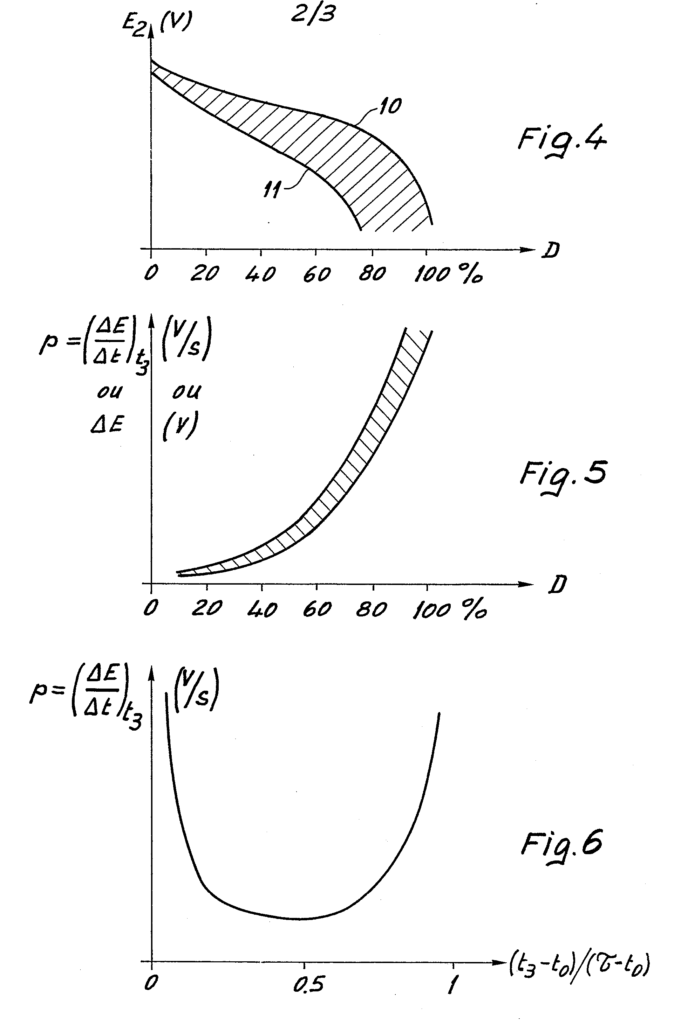

L'instant $t_3$ est choisi, pour une pile à l'état frais, dans le début de la zone où la pente p de la tangente à la courbe représentant la tension E en fonction du temps t varie peu, comme cela est montré sur la figure 6. L'idéal serait de se placer au point d'inflexion de la courbe représentant la tension E mais, comme on veut choisir un instant prédéterminé identique pour tous les états de décharge, on choisira cet instant $t_3$ de façon que pour un état de décharge faible on se situe au début de la zone où la pente change peu avec le temps, c'est-à-dire à un instant égal à environ $0.25\,(\tau-t_0)$. De cette façon, et puisque l'instant de transition $\tau$ diminue avec l'augmentation de la décharge, ce temps prédéterminé pour un état de décharge avancé représentera une valeur élevée du rapport $(t_3-t_0)/(\tau-t_0)$, c'est-à-dire environ $0.75\,(\tau-t_0)$.

La relation existant entre $p = \Delta E/\Delta t$ et D est représentée sur la figure 5. On constate que cette courbe présente une variation plus rapide et moins de dispersion que celle de la figure 4, cette dernière donnant la relation entre $E_2$ et D. Ceci explique pourquoi les résultats obtenus dans le procédé de mesure selon l'invention sont plus précis que ceux fournis par le procédé connu.

Un appareil électronique, mettant en oeuvre le procédé de mesure selon l'invention et permettant de déterminer de façon simple, rapide, non destructive et précise l'état de décharge d'une pile, sera maintenant décrit. Ce procédé nécessitant la mesure de la pente de la tangente à la courbe de la tension de la pile en fonction du temps, cette pente sera assimilée à la mesure d'une différence de tension de la pile à deux instants successifs prédéterminés.

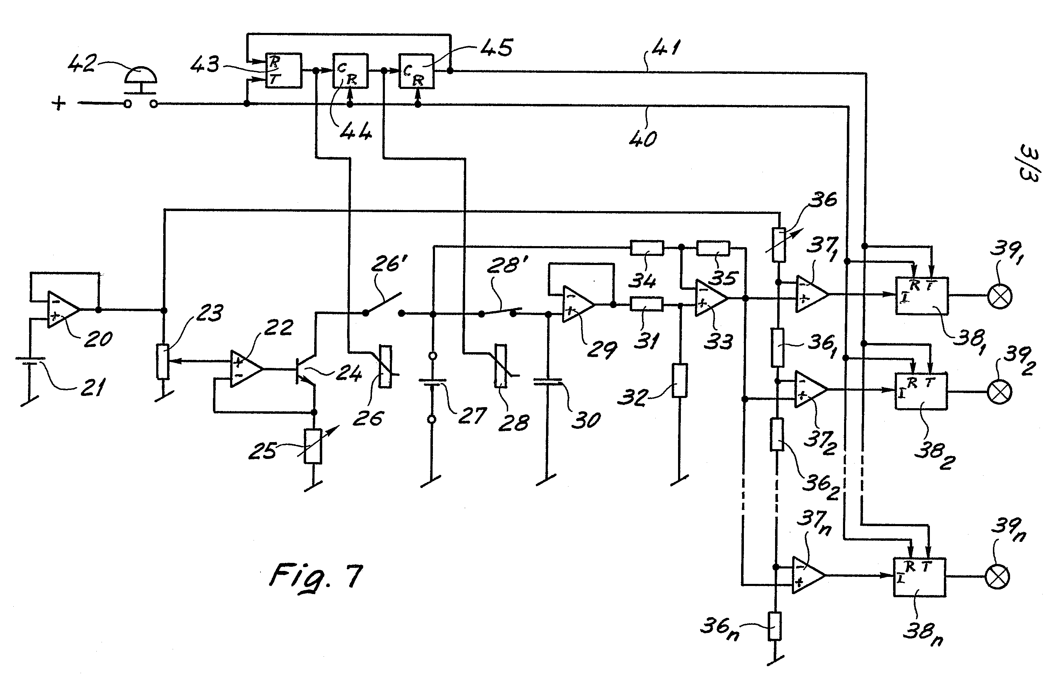

Le schéma de l'appareil est représenté sur la figure 7. Ce schéma comporte un amplificateur différentiel 20 dont l'entrée non inverseuse est reliée à un pôle d'une source de tension de référence 21, par exemple une pile ou une diode Zener, et l'entrée inverseuse à la sortie de cet amplificateur. De cette façon l'amplificateur 20 délivre à sa sortie, sous une impédance très faible, une tension égale à la tension de la source de référence 21. Un amplificateur différentiel 22 a son entrée non inverseuse reliée au curseur d'un potentiomètre 23 lequel est connecté entre la sortie de l'amplificateur 20 et un point de masse auquel est également relié l'autre pôle de la source de tension 21. La sortie de l'amplificateur 22 est reliée à la base d'un transistor bipolaire 24 dont l'émetteur est connecté à l'entrée inverseuse de l'amplificateur 22 et à un pôle d'une résistance variable 25, l'autre pôle de cette résistance étant relié à un point de masse. Le rôle de l'amplificateur 22 étant de maintenir la tension aux bornes de la résistance 25 égale à la tension au curseur du potentiomètre 23, l'ensemble formé de l'amplificateur 22 et du transistor 24 ainsi montés fonctionne en absorbeur de courant constant dont l'intensité peut être réglée par le potentiomètre 23 ou la résistance 25. Le collecteur du transistor 24 est relié à un pôle d'un contact 26' d'un relais 26. La pile dont on veut mesurer l'état de décharge D est référencée 27. Une borne de cette pile est reliée à un point de masse et l'autre borne à l'autre pôle du contact 26'. Un pôle d'un contact 28' d'un relais 28 est relié à un pôle de la pile 27 et l'autre pôle de ce contact 28' à l'entrée non inverseuse d'un amplificateur différentiel 29 ainsi qu'à un pôle d'un condensateur 30 dont l'autre pôle est connecté à un point de masse. La sortie de l'amplificateur 29 est reliée à l'entrée inverseuse de cet amplificateur, lequel présente ainsi un gain unitaire, une très haute impédance d'entrée et une basse impédance de sortie. Deux résistances 31 et 32 connectées en série relient la sortie de l'amplificateur 29 à un point de masse. Ces deux résistances définissent un diviseur de tension et leur point commun est relié à l'entrée non inverseuse d'un amplificateur différentiel 33. Deux résistances 34 et 35 sont branchées en série entre la sortie de l'amplificateur 33 et la borne de la pile 27 qui est reliée aux contacts 26' et 28'. Le point commun aux résistances 34 et 35 est relié à l'entrée inverseuse de l'amplificateur 33 lequel, ainsi monté, fournit à sa sortie une tension proportionnelle à la différence entre la tension présente aux bornes de la pile 27 et celle de la sortie de l'amplificateur 29, cette dernière tension étant égale à la tension aux bornes du condensateur 30. Le gain de l'amplificateur 33 peut être ajusté à l'aide des résistances 34 et 35. Une série de n amplificateurs différentiels $37_1$, $37_2 \ldots 37_n$, montés en comparateurs reçoivent tous, sur leur entrée non inverseuse, la tension de sortie de l'amplificateur 33 et, sur leur entrée inverseuse, une tension dégressive obtenue à partir d'un diviseur de tension formé d'une résistance variable 36 et des résistances $36_1$, $36_2 \ldots 36_n$, toutes ces résistances étant connectées en série entre la sortie de l'amplificateur 20 et un point de masse. Ainsi le point commun aux résistances 36 et $36_1$ est relié à l'entrée inverseuse de l'amplificateur $37_1$, le point commun aux résistances $36_1$ et $36_2$ à l'entrée inverseuse de l'amplificateur $37_2$, et le point commun aux résistances $36_{n-1}$ et $36_n$ a l'entrée inverseuse de l'amplificateur $37_n$. Le gain des amplificateurs $37_1$ à $37_n$ est choisi suffisamment élevé pour que chaque amplificateur fournisse à sa sortie un signal logique haut ou bas suivant que la différence entre les tensions existant sur ses entrées non inverseuse et inverseuse est respectivement positive ou bien négative ou nulle.

La sortie de l'amplificateur différentiel $37_1$ est reliée à une entrée I d'un registre $38_1$ et la sortie de ce registre à un élément indicateur $39_1$, par exemple une lampe. Il y a en tout n registres $38_1$ à $38_n$ et n éléments indicateurs $39_1$ à $39_n$.

Tous les éléments ayant le même indice sont connectés de la même manière que l'amplificateur $37_1$, le registre $38_1$ et la lampe $39_1$. Chaque registre $38_1$ à $38_n$ a une entrée R de remise à zéro. Toutes ces entrées sont reliées à une ligne de remise à zéro 40 activée par un poussoir de commande 42 lequel, en position poussée relie la ligne 40 à une tension d'alimentation fournie par une source d'alimentation non représentée, cette tension définissant un niveau logique haut. Chaque registre $38_1$ à $38_n$ a encore une entrée de tranfert T. Toutes ces entrées de transfert T sont reliées à une ligne de commande 41. Lorsque la ligne 41 passe de l'état logique bas à l'état logique haut, l'information présente à l'entrée I de chaque registre $38_1$ à $38_n$ est transférée à sa sortie. Lorsque la sortie d'un registre se trouve à un état logique haut, la lampe correspondante s'allume.

La séquence des mesures est obtenue à l'aide d'une bascule bistable 43 et de deux temporisateurs 44 et 45. La bascule bistable 43 a une entrée de remise à zéro R reliée à la ligne 41 et une entrée T de mise à l'état actif reliée à la ligne 40, faisant passer sa sortie de l'état logique bas à l'état logique haut. Le temporisateur 44 a une entrée de remise à zéro R reliée à la ligne 40 et une entrée de commande C reliée à la sortie de la bascule 43, cette sortie étant également connectée, par l'intermédiaire d'un amplificateur non représenté, à la bobine de commande du relais 26 qui ferme le contact 26' lorsque la bobine est parcourue par un courant en réponse à un niveau logique haut de la sortie. La sortie du temporisateur 44 passe de l'état logique bas à l'état logique haut $t_a$ secondes après que son entrée de commande C ait subi la même transition. Enfin le temporisateur 45 a également une entrée de remise à zéro R reliée à la ligne 40 et une entrée de commande C reliée à la sortie du temporisateur 44. Cette sortie est aussi connectée, par l'intermédiaire d'un amplificateur non représenté, à la bobine de commande du relais 28 qui ouvre le contact 28' lorsque la bobine est parcourue par un courant. La sortie du temporisateur 45 est reliée à la ligne 41 et passe de l'état logique bas à l'état logique haut $t_b$ secondes après que son entrée de commande C ait subi la même transition.

Les intervalles de temps $t_a$ et $t_b$ donnés par les temporisateurs 44 et 45 sont tels que $t_a = t_1-t_0$ et $t_b = t_1-t_0 + t_2-t_0$, $t_0$, $t_1$ et $t_2$ ayant été définis précédemment.

Le fonctionnnement de l'appareil de mesure dont le schéma est représenté sur la figure 7 est le suivant. Une fois que la pile à mesurer 27 a été mise en place, le bouton de commande 42 de l'appareil est actionné à un moment qui définit l'instant initial $t_0$. Cette manoeuvre met la ligne 40 temporairement à l'état logique haut, ce qui a pour effet de mettre la sortie de la bascule 43 à l'état logique haut, de remettre à zéro les temporisateurs 44, 45 ainsi que les registres $38_1$ à $38_n$ et d'éteindre les lampes $39_1$ à $39_n$. L'état logique haut de la bascule 43 entraîne la fermeture du contact 26' et enclenche le temporisateur 44. A l'instant initial $t_0$, les contacts 26' et 28' sont donc fermés puisque la sortie du temporisateur 44 se trouve à l'état logique bas à cet instant. Le transistor 24 monté en absorbeur de courant fait débiter à la pile 27 un courant de mesure constant i. Le condensateur 30 se charge à la tension de la pile et cette tension se retrouve à la sortie de l'amplificateur 29. Cette situation dure $t_a = t_1-t_0$ secondes.

Après cette intervalle de temps $t_1-t_0$, la sortie du temporisateur 44 passe à l'état logique haut, ce qui a pour effet d'enclencher le temporisateur 45 et d'ouvrir le contact 28'. Comme l'impédance d'entrée de l'amplificateur 29 est suffisamment élevée pour ne pas décharger le condensateur 30 de façon appréciable pendant la durée de la mesure de la pile, l'ouverture du contact 28' fait que le condensateur 30 garde en mémoire la tension qu'avait la pile 27 à l'instant $t_1$. Cette tension est égale à la tension $E_1$ précédemment définie et se retrouve à la sortie de l'amplificateur 29. La tension $E_1$, atténuée par le diviseur formé des résistances 31 et 32, est appliquée à l'entrée non inverseuse de l'amplificateur 33. L'entrée inverseuse de cet amplificateur reçoit en permanence une tension proportionnelle à la tension E de la pile 27, le facteur de proportionnalité étant fixé par les résistances 34 et 35. Les résistances 31, 32, 34 et 35 sont choisies de façon qu'à la sortie de l'amplificateur 33 apparaisse une tension de mesure proportionnelle à $E_1 - E$ et de même signe.

Après un intervalle de temps $\Delta t$, compté à partir de l'instant $t_1$ où l'entrée du temporisateur 45 passe à l'état logique haut, la sortie de ce temporisateur passe également à l'état logique haut. Cette transition de la sortie a lieu à l'instant $t_2 = t_1 + \Delta t$.

La tension de la pile à l'instant $t_2$ est égale à la tension $E_2$ précédemment définie, ce qui signifie qu'à la sortie de l'amplificateur 33 apparaît une tension de mesure proportionnelle à $\Delta E = E_1 - E_2$, car la tension du condensateur 30 est toujours égale à $E_1$. Cette tension de mesure est proportionnelle à la pente de la droite passant par les points A et B de la figure 2, laquelle est très voisine de la pente de la tangente à la courbe i correspondant à un instant $t_3$ compris entre les instants $t_1$ et $t_2$. La tension de mesure $\Delta E$ est donc représentative, au même titre que la pente de la tangente, de l'état de décharge D de la pile pour $t_1$ et $t_2$ donnés. Cette tension est appliquée aux amplificateurs ou comparateurs $37_1$ à $37_n$.

A l'instant $t_2$ la ligne de commande 41, qui est reliée à la sortie du temporisateur 45, passe à l'état logique haut. Ceci a pour effet de remettre à zéro la bascule 43. La sortie de cette bascule passant au niveau logique bas, le relais 26 n'est plus excité. Ceci entraîne l'ouverture du contact 26' et l'interruption du courant de décharge i de la pile 27.

Chaque comparateur $37_1$ à $37_n$ reçoit sur son entrée inverseuse une tension dérivée du diviseur formé par les résistances 36, $36_1$ ... $36_n$ et sur son entrée non inverseuse la tension de mesure. On supposera que chaque comparateur délivre à sa sortie un signal logique haut si la tension à son entrée inverseuse, dérivée du diviseur, est inférieure à la tension de mesure, et un niveau logique bas si la tension dérivée du diviseur est égale ou supérieure à la tension de mesure.

L'information existant à la sortie de chacun des comparateurs $37_1$ à $37_n$ est transférée dans les registres correspondants $38_1$ à $38_n$ lorsque la ligne de commande 41 passe, à l'instant $t_2$, du niveau logique bas au niveau logique haut. Un niveau logique haut de la sortie d'un comparateur entraîne un même niveau logique à la sortie du registre correspondant. Ceci a pour effet d'allumer parmi

13

0119547

les lampes $39_1$ à $39_n$ celles qui sont connectées aux registres dont la sortie est au niveau logique haut.

Dans ces conditions, suivant la valeur de la tension de mesure à la sortie de l'amplificateur 33, il y aura entre 0 et n lampes allumées. Grâce à un étalonnage convenable du diviseur de tension formé des résistances 36, $36_1$ à $36_n$, le nombre de lampes allumées pourra être choisi proportionel à la valeur D définissant l'état de décharge de la pile. Dans le cas d'une pile complétement déchargée toutes les lampes seront ainsi éteintes, et dans celui d'une pile neuve toutes les lampes seront allumées.

Le circuit restera dans cet état tant que le bouton 42 ne sera pas pressé de nouveau pour déclencher une autre mesure.

La description ci-dessus n'est qu'un exemple de réalisation de l'appareil. Des solutions digitales ou à microprocesseur sont aussi possibles.

L'intégration du circuit en vue de son utilisation dans une montre qui avertirait l'utilisateur de la fin de vie de la pile est aussi envisageable.

REVENDICATIONS

1. Procédé de mesure de l'état de décharge (D) d'une pile (1;27) consistant à décharger la pile (1;27) par un courant de mesure constant (i) à partir d'un instant initial ($t_o$), caractérisé en ce qu'il consiste en outre à mesurer, à un instant de mesure ($t_3$), la pente (p) de la tangente à la courbe représentant la variation de la tension (E) de la pile en fonction du temps (t), ladite pente (p) étant représentative de l'état de décharge (D) de la pile.

2. Procédé de mesure selon la revendication 1, caractérisé en ce que ledit instant de mesure est compris entre l'intant initial ($t_o$) et un instant ($\tau$) dit de transition où la tension de la pile en fonction du temps commence à diminuer très rapidement.

3. Procédé de mesure selon la revendication 2, caractérisé en ce que ledit instant de mesure est situé entre le 1/4 et les 3/4 de l'intervalle de temps séparant l'instant initial de l'instant de transition.

4. Procédé de mesure selon la revendication 1, caractérisé en ce que ledit courant de mesure, exprimé en mA, est compris entre 0,05 et 4 fois la valeur de la capacité de la pile, exprimée en mAh.

5. Procédé de mesure selon la revendication 1, caractérisé en ce que la mesure de la pente (p) comporte la mesure d'une première tension ($E_1$) aux bornes de la pile après un premier intervalle de temps ($t_1$-$t_o$) compté à partir de l'instant initial ($t_o$) et la mesure d'une deuxième tension ($E_2$) aux bornes de la pile après un deuxième intervalle de temps ($t_2$-$t_o$) compté à partir de l'instant initial ($t_o$), ladite pente étant sensiblement égale au quotient de la différence entre la première et la deuxième tension mesurée et de la différence entre le deuxième et le premier intervalle de temps.

6. Procédé de mesure selon la revendication 5, caractérisé en ce que le premier intervalle de temps est compris entre 1 et 30 secondes et que le deuxième intervalle de temps est compris entre 5 et 100 secondes.

7. Appareil de mesure pour la détermination de l'état de décharge (D) d'une pile (27) comprenant des moyens (22;24) pour décharger la pile par un courant de mesure constant (i) et des moyens de commutation (26;26') permettant de relier lesdits moyens de décharge à la pile à un instant initial ($t_0$), caractérisé en ce qu'il comporte en outre :

- des moyens (43;44;45) permettant de déterminer, à partir de l'instant initial, un premier ($t_1$-$t_0$) et un deuxième ($t_2$-$t_0$) intervalle de temps;

- des moyens (28;28';30) permettant de mesurer et de mémoriser une première tension ($E_1$) de la pile après le premier intervalle de temps;

- des moyens (29;33) permettant de mesurer la différence entre la première tension ($E_1$) de la pile et une deuxième tension ($E_2$) de la pile, mesurée après le deuxième intervalle de temps; et

- des moyens ($39_1$...$39_n$) permettant d'afficher ladite différence entre la première et la deuxième tension de la pile, représentative de la pente (p) de la tangente à la courbe représentant la variation de la tension (E) de la pile en fonction du temps (t) pour tout instant de mesure ($t_3$) compris dans le second intervalle de temps, en dehors du premier intervalle de temps, ladite pente étant elle-même représentative de l'état de décharge de la pile.

0119547

1/3

Fig.1

Fig.2

Fig.3

$E_2$ (V)

10

11

D

0   20   40   60   80   100 %

Fig.4

$p = \left(\dfrac{\Delta E}{\Delta t}\right)_{t_3}$ (V/s)

ou

$\Delta E$

ou

(V)

D

0   20   40   60   80   100 %

Fig.5

$p = \left(\dfrac{\Delta E}{\Delta t}\right)_{t_3}$ (V/s)

$(t_3 - t_0)/(\tau - t_0)$

0               0.5               1

Fig.6

0119547

Fig. 7

## DOCUMENTS CONSIDERES COMME PERTINENTS

| Catégorie | Citation du document avec indication. en cas de besoin, des parties pertinentes | Revendication concernée | CLASSEMENT DE LA DEMANDE (Int. Cl. 3) |
|---|---|---|---|
| A,D | JOURNAL OF THE ELECTROCHEMICAL SOCIETY, vol. 123, no. 9, septembre 1976, pages 1271-1276; F. KORNFEIL: "Some observations on the prediction of the state of discharge of batteries" * En entier * | 1 | G 01 R 31/36 H 01 M 10/44 |
| | --- | | |
| A | FR-A-2 269 207 (SINDETEC) * Page 2, ligne 17 - page 6; figures 2a-2d * | 1 | |
| | --- | | |
| A | US-A-4 028 616 (C.R. STEVENS) | 7 | |
| | ----- | | |

DOMAINES TECHNIQUES RECHERCHES (Int. Cl. 3)

G 01 R
H 01 M
G 04 C
H 02 J

Le présent rapport de recherche a été établi pour toutes les revendications

| Lieu de la recherche LA HAYE | Date d'achèvement de la recherche 15-06-1984 | Examinateur KUSCHBERT D.E. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82